# FASCICULE DE BREVET EUROPEEN

(11) **EP 2 095 410 B1**
(45) Date de publication et mention de la délivrance du brevet: **10.04.2013**
(21) Numéro de dépôt: 07871849.1
(22) Date de dépôt: 12.12.2007
(51) Int. Cl.: H01L 21/56, H01L 21/00, B23K 26/14

(54) **PROCEDE ET INSTALLATION DE MISE A NU DE LA SURFACE D'UN CIRCUIT INTEGRE**
VERFAHREN UND INSTALLATION ZUR BELICHTUNG DER OBERFLÄCHE EINER INTEGRIERTEN SCHALTUNG
METHOD AND EQUIPMENT FOR EXPOSING THE SURFACE OF AN INTEGRATED CIRCUIT

(30) Priorité: 28.12.2006 FR 0611489
(43) Date de publication de la demande: 02.09.2009
(73) Titulaire: Centre National d'Etudes Spatiales (C.N.E.S.), 75001 Paris (FR)
(72) Inventeur: DESPLATS, Romain, F-31320 Castanet Tolosan (FR); OBEIN, Michaël, F-14740 Secqueville en Bessin (FR)
(74) Mandataire: Jacobson, Claude
(86) Numéro de dépôt international: PCT/FR2007/002056
(87) Numéro de publication internationale: WO 2008/090281

(56) Documents cités:
- JP-A- 2001 049 014
- US-A- 4 689 467
- US-A- 4 714 516
- US-A1- 2004 150 096
- US-A1- 2005 221 586
- US-B1- 6 699 780
- BUTLER ET AL.: "Multichip module packaging of microelectromechanical systems" SENSORS AND ACTUATORS A, vol. 70, no. 1-2, 1 octobre 1998 (1998-10-01), pages 15-22, XP002443624

## Description

La présente invention concerne un procédé de mise à nu d'un circuit intégré par ablation d'une enveloppe de polymère recouvrant initialement le circuit intégré.

Il est connu d'utiliser des lasers de forte puissance pour enlever de la matière de revêtement recouvrant une pièce. L'article de Butler et al. « Multichip module packaging of micro electronical systems » publié dans la revue Sensors and actuators A, volume 70, n°1 à 2 du 1er octobre 1998, pages 15 à 22, les demandes de brevet US-A-4 689 467, US 2005/221586 A1, US-A-4 714 516, JP 2001/049014 A, US 2004/150096 A1, et le brevet US-B1- 6 699 780 décrivent de tels procédés à laser.

Les circuits intégrés sont gravés dans un bloc de silicium muni de connexions latérales réalisées notamment en cuivre permettant la connexion du circuit interne à un circuit imprimé portant d'autres composants électroniques.

Le circuit intégré est encapsulé dans une enveloppe de polymère maintenant rigidement les pattes de connexion en permettant la manipulation du circuit et en assurant sa protection.

Pour l'analyse du fonctionnement des circuits intégrés, il est nécessaire dans certains cas de pouvoir accéder au circuit intégré tout en conservant son intégrité et ses capacités de fonctionnement.

A cet effet, il est connu de procéder localement à l'ablation de l'enveloppe de polymère permettant de mettre à nu une surface du circuit intégré.

Pour l'ablation de l'enveloppe de polymère, il est connu d'appliquer un faisceau laser de forte puissance sur l'enveloppe de polymère et de balayer le circuit intégré afin de provoquer la dégradation de l'enveloppe.

Ce procédé est mis en oeuvre dans une installation spécifique permettant de contrôler avec précision l'application du laser.

En effet, une application trop importante au faisceau laser conduit à une attaque du silicium et à une détérioration du circuit.

Pour éviter une telle détérioration, le laser est appliqué de manière modérée mais des îlots de polymère restent en place sur le circuit, ce qui nuit à l'observation ultérieure du circuit intégré.

Il est par ailleurs connu d'utiliser un plasma pour attaquer l'enveloppe de polymère au droit du circuit intégré. Cette attaque s'effectue dans une enceinte étanche adaptée dans laquelle est disposé le circuit. Cette enceinte permet d'établir un plasma au-dessus du circuit.

Le plasma provoque une attaque de l'enveloppe polymère. Toutefois, l'action du plasma est très lente et ne permet que de retirer une épaisseur très réduite de l'enveloppe plastique.

Le document US 4 689 467 décrit un dispositif de découpe d'une pièce de fabrication réalisée en un seul matériau. Le dispositif comporte un laser et un pistolet à plasma.

Toutefois, ce laser présente une puissance trop élevée pour pouvoir être utilisé en microélectronique.

De plus, le pistolet à plasma est avant tout un générateur auxiliaire d'énergie qui chauffe la pièce de fabrication pour la découper plus rapidement. Ce pistolet ne peut pas être utilisé pour mettre à nu un circuit intégré car il aurait pour effet de faire fondre la couche de polymère, les conducteurs de liaison ainsi que les composants du circuit. Aussi, un tel pistolet à plasma endommagerait le circuit imprimé non encore intégré.

Comme indiqué en ligne 40, colonne 11 de ce document, une décharge Corona, c'est- à dire un arc électrique est généré pour créer le plasma. Or un tel arc électrique détruirait le circuit intégré s'il était utilisé pour mettre à nu un circuit intégré. Le jet issu du pistolet à plasma a un effet de micro sablage à l'échelle atomique.

En conséquence, le dispositif de découpe décrit dans ce document ne peut pas être utilisé pour mettre à nu un circuit intégré.

Le document intitulé « Multichip module packaging of Microelectromechanical systems » décrit un procédé de mise à nu d'une micro plaquette d'un micro-système électromécanique (MEMS). Selon ce procédé, deux couches de diélectrique recouvrant la micro plaquette sont retirées par ablation lors de l'application d'abord d'un faisceau laser puis d'une attaque plasma.

Toutefois, ce document ne mentionne nullement que la micro plaquette est maintenue sur le même support et dans la même enceinte pendant l'application du laser et l'application du plasma. Or, lors du déplacement de la micro plaquette après application du laser, il n'est plus possible de réaliser l'attaque plasma et exactement à l'endroit choisi, compte tenu de la taille des portions du circuit intégré à traiter.

Compte tenu de la faible capacité d'ablation du plasma, il est connu de préparer l'échantillon en réduisant mécaniquement ou chimiquement l'épaisseur de l'enveloppe polymère disposée au-dessus du circuit intégré.

A cet effet, suivant un premier mode de mise en oeuvre, un polissage à plat de l'enveloppe du circuit intégré est effectué à partir d'une meule, permettant ainsi de ne laisser qu'une faible épaisseur de l'enveloppe qui est ensuite éliminée par l'action du plasma.

Suivant une autre mode de mise en oeuvre, l'essentiel de l'épaisseur de l'enveloppe est éliminée par une attaque chimique à l'aide d'un acide et notamment d'acide nitrique ou sulfurique.

L'action de l'acide est délicate à arrêter et peut causer un endommagement du circuit ou des connexions électriques au boîtier.

Ces deux procédés de mise en oeuvre prévoient ainsi une préparation de l'échantillon en dehors de l'enceinte d'application du plasma, puis une étape ultérieure de traitement de l'échantillon au plasma pour retirer la dernière épaisseur de polymère alors que l'échantillon a été placé dans l'enceinte dans laquelle est créé le plasma.

De tels procédés, sont relativement longs à mettre en oeuvre puisqu'ils nécessitent la mise en oeuvre de deux techniques d'ablation différentes.

L'invention a pour but de proposer un procédé de mise à nu de la surface d'un circuit intégré qui puisse être mis en oeuvre rapidement tout en permettant d'obtenir un état de surface satisfaisant du circuit intégré.

A cet effet, l'invention a pour objet un procédé de mise à nu d'un circuit intégré par ablation d'une enveloppe de polymère recouvrant initialement le circuit intégré, caractérisé en ce qu'il comporte une application combinée d'un rayonnement laser et d'un plasma sur l'enveloppe recouvrant initialement le circuit intégré, l'application combinée étant réalisée dans un même enceinte.

Des modes particuliers de mise en oeuvre sont décrits dans les revendications dépendantes.

L'invention a également pour objet un procédé de test d'arrachement des conducteurs de liaison d'un circuit intégré initialement recouvert par une enveloppe de polymère comprenant :
- une étape initiale de mise à nu du circuit intégré et des conducteurs de liaison par un procédé tel que décrit ci-dessus, et
- une étape de test d'arrachement des conducteurs ainsi mis à nu.

L'invention a enfin pour objet une installation de mise à nu d'un circuit intégré par ablation d'une enveloppe de polymère recouvrant initialement le circuit intégré comportant :
- des moyens d'application d'un rayonnement laser vers la surface du circuit intégré ;
- des moyens d'application, combinée à l'application d'un rayonnement laser, d'une attaque par plasma sur l'enveloppe recouvrant initialement le circuit intégré ; et
- une platine de support du circuit intégré lors de son traitement et les moyens d'application du rayonnement laser et les moyens d'application du plasma sont propres à agir sur la même platine de support.

L'invention sera mieux comprise à la lecture de la description qui va suivre, donnée uniquement à titre d'exemple et faite en se référant aux dessins sur lesquels :
- la Figure 1 est une vue schématique d'un premier mode de réalisation d'une installation de mise à nu d'un circuit intégré selon l'invention ;
- la Figure 2 est une vue en perspective de la chambre de l'installation de la Figure 1 ;
- la Figure 3 est un organigramme du procédé mis en oeuvre pour la mise à nu d'un circuit intégré ;
- la Figure 4 est une vue schématique en élévation d'un autre mode de réalisation pour l'installation de mise en oeuvre du procédé ; et
- la Figure 5 est un schéma montrant les étapes successives de traitement d'un échantillon comprenant deux circuits dans une même enveloppe.

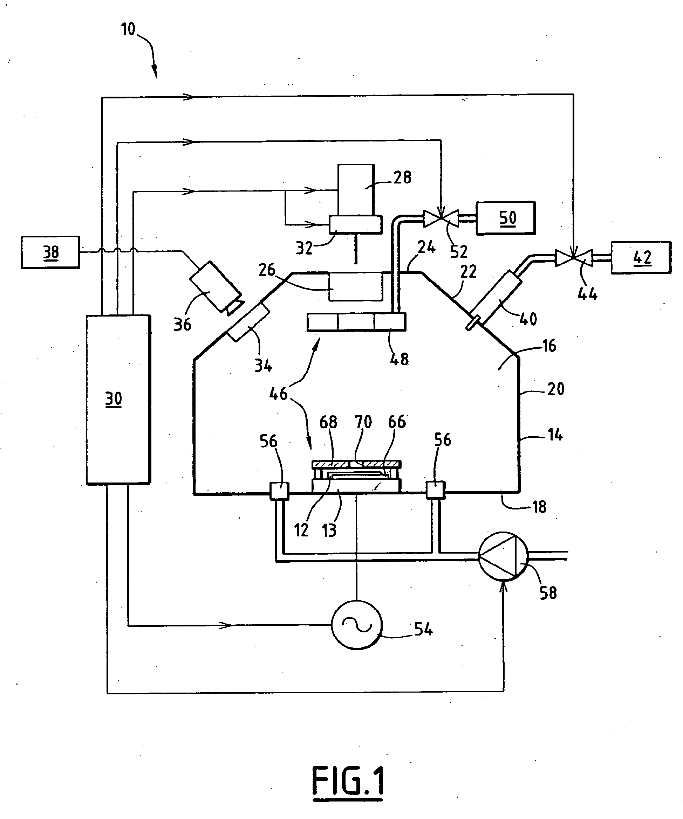

L'installation 10 illustrée sur la Figure 1 est propre à assurer la mise à nu d'un échantillon 12 formé d'un circuit intégré contenu dans une enveloppe de polymère par mise en oeuvre successive d'un faisceau laser et d'un plasma sous vide. Le circuit 12 est porté par une platine 13.

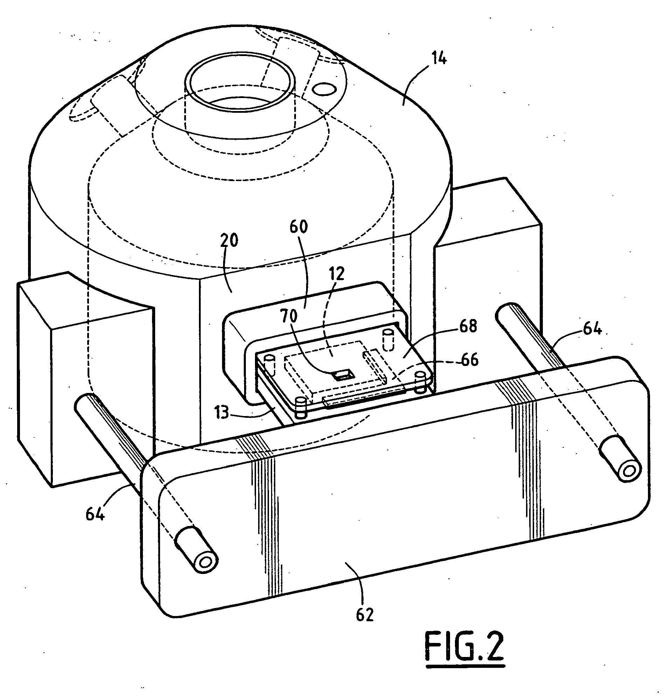

Cette installation comporte une chambre à vide 14 délimitant une enceinte étanche 16. La chambre 14 est représentée plus en détail sur la Figure 2.

La chambre 14 présente un fond plat 18, une paroi latérale généralement cylindrique 20 et un couvercle 22 de forme générale tronconique surmontée par un plafond plat 24. Le plafond 24 présente une fenêtre transparente 26 disposée au droit de la partie centrale du fond 18 où se trouve la platine 13 sur la Figure 1 lorsque celle-ci est en position de traitement du circuit.

Une source laser 28 est disposée à l'extérieur de la chambre 14 en regard de la fenêtre 26 et est tournée vers l'échantillon 12. Ce laser est par exemple un laser Galvano, de type Nd :Yag ou un laser Excimer. Ce laser est relié pour sa commande par une unité centrale de pilotage 30.

L'unité centrale de pilotage 30 est formée par exemple d'un ordinateur associé à des cartes d'entrée et de sortie.

La source laser 28 est portée par des moyens 32 de déplacement du faisceau laser dans le plan du circuit 12 suivant deux directions perpendiculaires l'une à l'autre. Ces moyens de déplacement sont reliés à l'unité centrale de pilotage 30 propre à commander la position du laser et permettant un balayage de la surface supérieure du circuit 12 par le faisceau laser.

Par ailleurs, la paroi tronconique 22 du couvercle est pourvue d'une fenêtre transparente 34 en arrière de laquelle est disposée une caméra d'observations 36 placée à l'extérieur de l'enceinte et dirigée pour observer l'échantillon 12 disposé dans l'enceinte.

La caméra 36 est reliée à un moniteur d'observations 38 permettant de suivre l'évolution de la mise à nu de la surface du circuit intégré.

Comme illustré sur la figure 1, l'axe optique de la caméra 36 est décalé angulairement par rapport à la normale au circuit 12.

Ainsi, avantageusement, un circuit correcteur d'images est interposé entre la caméra 36 et le moniteur 38. Ce circuit correcteur d'images est propre à mettre en oeuvre un algorithme de traitement d'images permettant de redresser l'image initialement sous forme de trapèze obtenue du circuit afin que cette image ait une forme rectangulaire comme si celle-ci avait été observée avec un axe optique de caméra perpendiculaire à la normale au circuit.

En variante, un miroir ou un ensemble de miroirs est disposé à l'intérieur de l'enceinte entre la caméra 36 et le circuit 12, afin de modifier le faisceau entre la caméra et le circuit et ainsi assurer, par une correction des angles, un redressement de l'image.

Suivant encore un mode de réalisation, deux caméras avec des angles différents sont positionnées pour observer le circuit. Les images obtenues par les deux caméras sont adressées à une unité de traitement d'images permettant de produire une image stéréoscopique du circuit.

Suivant un mode de réalisation avantageux, les trois approches précédentes sont combinées. Ainsi, deux caméras sont par exemple mises en oeuvre pour obtenir une image stéréoscopique du circuit alors qu'une troisième caméra est associée à un jeu de miroirs ou à une unité de traitement d'images afin d'obtenir une image rectangulaire redressée du circuit.

Une buse 40 d'injection d'un gaz de nettoyage est ménagée au travers de la paroi tronconique 22. Cette buse est dirigée vers le circuit intégré 12. La buse 40 est alimentée depuis une source 42 de gaz de nettoyage sous pression. L'alimentation de la buse 40 à partir du gaz contenu dans la source 32 est pilotée par l'unité centrale de pilotage 30 pilotant une vanne 44.

Le gaz contenu dans la source 42 projeté par la buse 40 est par exemple formé de dioxyde de carbone propre à pulvériser les matières non ôtées par le plasma.

L'enceinte comporte en outre des moyens 46 d'établissement d'un plasma sur la surface à mettre à nu du circuit intégré 12. Ces moyens 46 comportent une couronne 48 d'injection d'un gaz propre à être ionisé. Cette couronne est disposée suivant l'axe de la chambre à l'intérieur de la chambre au voisinage de la fenêtre 26. La couronne 48 comporte un ensemble de perforations réparties à sa périphérie et dirigées vers le circuit 12.

La couronne 48 est alimentée par une source de gaz de ionisation 50 disposée à l'extérieur de la chambre à laquelle la couronne est reliée au travers d'une vanne 52 pilotée par l'unité centrale de pilotage 30.

Le gaz contenu dans la source 50 est formé par exemple d'un mélange d'oxygène et de tétra-fluorure de carbone.

Les moyens 46 d'établissement d'un plasma comportent en outre un générateur radio fréquence 54 relié à la platine 13 de support de l'échantillon. Ce générateur 54 est propre à créer un champ électromagnétique intense propre à provoquer l'ionisation du gaz contenu dans la chambre.

Le générateur 54 est relié pour son pilotage à l'unité centrale de pilotage 30.

Des bouches d'aspiration 56 sont disposées dans le fond 18 autour de l'échantillon 12. Ces bouches sont reliées à une pompe à vide 58 pilotées par l'unité centrale de pilotage 30. Les bouches 56 sont propres à aspirer le gaz contenu dans la chambre ainsi que les débris obtenus lors de la dislocation de l'enveloppe sous l'action du rayonnement laser et du plasma.

Comme illustré sur la Figure 2, la platine de support de l'échantillon 13 est montée déplaçable à coulissement par rapport à la chambre 14. La chambre 14 comporte dans sa paroi latérale 20 une ouverture d'introduction 60 au travers de laquelle la platine 13 supportant l'échantillon 12 est montée coulissante. La platine 13 est solidaire d'un tiroir coulissant 62 montée déplaçable sur deux coulisses latérales 64 solidaires de la chambre 14. Le tiroir 64 est déplaçable entre une position de mise en place du circuit dans laquelle la platine est essentiellement au dehors de la chambre 14 et la position de traitement du circuit dans laquelle la platine 13 et notamment l'échantillon se trouvent au droit de la fenêtre 26.

La platine 13 et le tiroir 62 sont pourvus d'un joint d'étanchéité permettant d'assurer l'étanchéité de la chambre 16 lorsque la platine est en position de traitement de l'échantillon. La platine comporte une équerre 66 de positionnement du circuit intégré 12.

Un masque de protection 68 est enfin disposé au-dessus du circuit et porté par la platine 13. Ce masque délimite un orifice 70 pour le passage du faisceau laser et du plasma au droit de la partie devant être mise à nu du circuit intégré.

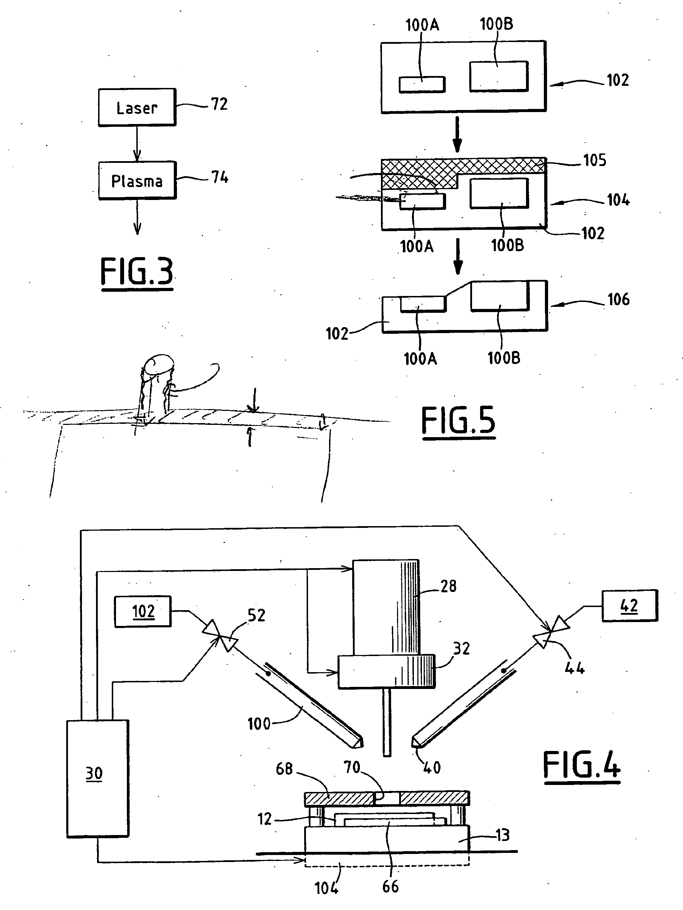

Pour la mise à nu d'un circuit intégré, le circuit est d'abord positionné sur la platine 13 au dessous du masque 68 puis la platine est introduite dans la chambre. Le vide est ensuite effectué dans la chambre à partir de la pompe 58. La surface devant être mise à nu du circuit intégré est ensuite soumise à un rayonnement laser depuis la source 28 à l'étape 72 de la Figure 3. Le faisceau laser mis en oeuvre a de préférence une puissance comprise entre 1 et 50 Watts. Il est appliqué pendant une durée par exemple comprise entre 5 et 30 secondes. Le faisceau laser est en particulier appliqué afin de permettre l'ablation de l'enveloppe du circuit sur l'essentiel de son épaisseur, ne laissant qu'une épaisseur résiduelle comprise entre 50 et 200 µm et de préférence égale à 100 µm.

Pendant le traitement par le faisceau laser, l'évolution du circuit est observée depuis la caméra 36. Les débris de l'enveloppe retirés sont recueillis par les bouches 56.

Après qu'il ne reste plus que la couche résiduelle de polymère, un plasma est établi au voisinage du circuit 12 à l'étape 74 sans que le circuit n'ait été sorti de l'enceinte 16 et alors que celle-ci est toujours sous vide. Ce plasma est établi par injection de gaz depuis la couronne 48 et création d'un champ magnétique par le générateur 54.

Le plasma présente de préférence les caractéristiques propres à assurer une dislocation de la résine présente. La température, le niveau de pression de travail, et la nature des gaz employés sont choisis suivant le type et l'épaisseur de résine.

Il est appliqué pendant une durée comprise entre 30 et 240 minutes.

La présence du plasma permet, par l'action des particules ionisées une élimination complète de la couche résiduelle de polymère, même dans les parties en contre dépouille du circuit et sous les connections en cuivre.

Pendant l'application du plasma, des pulvérisations périodiques de dioxyde de carbone permettent l'élimination des résidus obtenus.

Suivant une variante de réalisation, la première étape 72 de mise en oeuvre du rayonnement laser s'effectue alors que le circuit intégré est soumis à un plasma.

Lorsque cela s'avère nécessaire, par exemple du fait de l'inégale épaisseur de la couche résiduelle de polymère recouvrant le circuit, les étapes 72 et 74 successives d'application d'un laser et d'un plasma sont réitérées afin de permettre l'ablation de la couche résiduelle dans les régions où celle-ci est la plus épaisse par l'intermédiaire du faisceau laser, après une action antérieure du laser et du plasma. A l'issue de la seconde application du rayonnement laser, une dernière étape de traitement par plasma est appliquée.

Suivant encore un mode de réalisation, le plasma créé dans la chambre 16 est entretenu non pas par la création d'un champ magnétique grâce au générateur 54 mais par la soumission à un rayonnement laser de puissance adaptée, ce rayonnement étant propre à ioniser le gaz dans la chambre mais étant insuffisant pour en lui-même attaquer l'enveloppe de polymère.

On conçoit qu'avec un tel procédé, le circuit peut être mis à nu de manière très précise, du fait de l'action finale du plasma.

Par ailleurs, la mise en oeuvre combinée du rayonnement laser et du plasma dans une même enceinte réduit les manipulations et permet donc un procédé de mise à nu très rapide et facile à mettre en oeuvre. Le fait de rester sous vide entre les deux opérations permet de ne pas oxyder les métaux constituant le circuit ou les connexions du circuit avec l'air ambiant.

L'action combinée du laser dans un premier temps et du plasma dans un second temps permet une mise à nu très satisfaisante des fils de connexion reliant le circuit intégré proprement dit aux pattes de connexion latérales faisant saillie par rapport au boîtier. En effet, l'action du laser permet de dégager la surface supérieure de ces fils de connexions alors que le polymère situé au-dessous des fils de connexion est retiré par l'action du plasma, sans que les fils de connexion ne soient endommagés.

Une telle mise à nu des fils de connexion est particulièrement utile pour une étape ultérieure de tests d'arrachement des fils de connexion, les résultats obtenus aux tests d'arrachement n'étant pas modifiés par l'action agressive mise en oeuvre pour retirer le polymère.

Sur la Figure 4 est illustré un autre mode de réalisation de mise à nu d'un circuit intégré. Sur cette Figure, les éléments identiques ou correspondant à ceux de la Figure 1 sont désignés par les mêmes numéros de référence.

Dans ce mode de réalisation, le plasma sous vide est remplacé par un plasma atmosphérique. Ainsi, la chambre 14 est supprimée. L'échantillon 12 supporté par la platine 13 est comme précédemment disposé en regard de la source laser 28 et des moyens 40, 42, 44 d'injection d'un gaz de nettoyage sont prévus.

Les moyens d'établissement d'un laser atmosphérique comporte une buse 100 de libération d'un gaz plasmatique reliée à une source de gaz 102 contenant de l'oxygène ou un mélange d'oxygène et de tétra-fluorures de carbone. Le laser est utilisé comme source d'excitation du gaz injecté afin de provoquer l'ionisation du gaz plasmatique.

Le procédé mis en oeuvre dans cette installation est identique à celui mis en oeuvre dans l'installation de la Figure 1, le circuit 12 étant soumis d'abord à un rayonnement laser puis soumis à une attaque par plasma.

Sur la figure 5 sont lustrées les étapes successives de la mise à nu de la surface de deux circuits intégrés dans un même boîtier formé de polymère.

De nos jours, il est connu d'associer plusieurs circuits intégrés 100A, 100B dans un même polymère 102, permettant ainsi d'avoir l'équivalent d'une carte électronique miniature. De tels circuits sont appelés couramment "système in package" (système dans un boîtier ou SIP) ou "multi cheap module" (module multi composant ou MCM). Les circuits intégrés disposés dans un tel boîtier peuvent avoir des surfaces supérieures situées à des niveaux différents, notamment lorsque les circuits intégrés ont des épaisseurs différentes.

Selon l'invention, le boîtier est d'abord soumis à l'étape 104 à un rayonnement laser visant à retirer l'essentiel de l'épaisseur de la couche de couverture. La partie retirée est notée 105. Cette ablation est réalisée par plusieurs passes effectuées avec le rayonnement laser, le nombre de passes étant plus important au-dessus du circuit dont la face supérieure est la plus profonde. Ainsi, le laser est appliqué de manière à laisser subsister sur chacun des circuits une couche résiduelle de polymère 102 de sensiblement la même épaisseur.

Ensuite, comme illustré à l'étape 106, les circuits intégrés 100A, 100B sont soumis à un plasma assurant l'ablation simultanée de la couche résiduelle de polymère restant au-dessus des différents circuits.

Quel que soit le mode de réalisation de l'installation, suivant un mode de mise en oeuvre particulièrement avantageux de l'invention, le masque de protection 68 est initialement une plaque pleine formée de polymère ou de métal. L'orifice 70 est directement usiné par le rayonnement laser issu du laser 28. Ainsi, l'ouverture est positionnée de manière très précise et présente une forme exactement satisfaisante pour le traitement du circuit placé au-dessous. Un tel ajustement est difficile à réaliser manuellement avec un positionnement mécanique d'un masque pré-usiné.

Par ailleurs, si au cours du traitement du circuit, il apparaît que d'autres zones du circuit doivent être étudiées, lesquelles sont couvertes par le masque de protection 68, un orifice complémentaire est ménagé dans le masque de protection 68 par action du rayonnement laser issu du laser 28 pour créer une autre zone de travail.

De même, en variante, l'orifice 70 initial est agrandi par l'action du laser.

L'attaque plasma réalisée au cours de l'étape 74 est une gravure physico-chimique (RIE : Reactive Ion Etching). Le plasma est généré en créant un champ magnétique dans un gaz à une pression allant généralement de 10mTorr à 1000 mTorr. C'est un plasma dit basse pression.

Le champ magnétique est créé par le générateur radiofréquence 54 connecté à des électrodes placées dans l'enceinte 16 dans l'environnement du mélange d'oxygène et de tétra-fluorure de carbone à basse pression. Le champ magnétique ionise les molécules du mélange de gaz en les dépouillant de leurs électrons, créant ainsi le plasma.

Le circuit intégré 12 absorbe les électrons libres accélérés par le champ magnétique de sorte qu'il se charge négativement. Le plasma est au contraire chargé positivement en raison de sa forte concentration d'ions positifs comparés aux électrons libres. En raison de cette importante différence de potentiel, des ions positifs se déplacent vers le circuit 12 où ils collisionnent avec le polymère résiduel et le polymère situé sous les conducteurs de liaison à attaquer chimiquement. Les ions réagissent chimiquement avec le polymère résiduel et éjectent une partie de ce polymère en transférant leur énergie cinétique.

L'attaque plasma est réalisée pendant ou après l'application du laser alors que le circuit intégré 12 est maintenu sur la même platine de support et que cette dernière n'est pas déplacée.

En variante, l'application du rayonnement laser est effectuée jusqu'à ce que l'épaisseur de la couche de polymère résiduelle au-dessus du circuit intégré soit comprise entre 200 µm et 0 µm.

La puissance du laser utilisé est d'environ 0,5 Watts par cm².

Selon un mode de réalisation de l'invention, le procédé de mise à nu de la surface d'un circuit intégré est réalisé selon les étapes décrites ci-dessous.

L'échantillon est un composant électronique qui présente une taille d'environ quelques cm². Ce composant est enrobé dans une résine à base de polymère (aspect plastique noir). Ce composant doit être ouvert de façon à mettre à nu le circuit intégré. Lors de la fabrication de ce circuit intégré, le circuit intégré est monté sur une armature généralement métallique sur laquelle se trouvent les broches (ou pattes) de connexions extérieures. La connexion entre le circuit intégré et les broches se fait par des conducteurs de liaison soudés d'une part et d'autre.

L'ensemble est enrobé dans la résine à base de polymère ne laissant que l'extrémité des broches de connexion à nu. Dans le processus d'enrobage, le circuit intégré se trouve rarement placé exactement au centre et encore moins dans un plan parfaitement parallèle avec la surface de l'enrobage du composant.

L'épaisseur de polymère à retirer n'est donc pas uniforme sur cette surface pour mettre à nu la surface du circuit intégré.

D'une manière préférentielle, une image au rayon X est faite du composant de façon à estimer la taille du circuit intégré. Par corrélation de cette même image rayon X avec une image à l'échelle du composant, obtenue avec une caméra optique calibrée, la position du circuit intégré peut être mesurée (vue par-dessus) afin de repositionner la zone d'application du laser et du plasma par rapport au composant lui-même.

Dans notre cas, le circuit intégré présente une taille de 200 µm x 200 µm.

Le composant électronique est alors positionné sur une platine pour être introduit dans le dispositif selon l'invention.

L'orifice sert à protéger les broches extérieures de l'échantillon. L'orifice 70 du masque de protection 68 présente une taille d'environ 1 millimètre carré. Dans cet orifice, l'application combinée du laser et du plasma est réalisée sur une zone prédéfinie du circuit intégré.

La mesure de position de la zone d'application est alors alignée sur le composant positionné sur la platine de support 13. Ce positionnement peut se faire de multiples façons. Soit avec un système de métrologie.qui permet la mesure des dimensions par rapport à un repère de la platine, soit avec une caméra optique étalonnée ou encore un pointeur laser motorisé. De même les hauteurs peuvent être mesurées soit avec un système de métrologie (palpeur motorisé), soit avec un système d'interférométrie, soit avec une caméra munie d'un système étalonné en hauteur.

Pour un premier composant, les épaisseurs de résines ne peuvent être mesurées avec précision. Aussi, une zone plus large que le circuit est astucieusement définie sur laquelle le laser et/ou le plasma sera appliqué.

Une première ablation laser est lancée sur une zone de 220µm x 220 µm, de manière à couvrir la zone du circuit intégré de 200 µm x 200 µm. Après quelques minutes l'opération est arrêtée pour contrôler la hauteur de résine enlevée. La hauteur est mesurée préférentiellement dans l'enceinte 16 de façon à éliminer les risques d'erreur de repositionnement de la platine de support 13 dans l'enceinte. En effet, il est très difficile de repositionner un élément mécanique à moins de quelques dizaines de microns. Un tel repositionnement serait un risque d'erreur qui nuirait au succès d'ouverture du composant et les étapes nécessaires rallongeraient de manière excessive la durée totale de l'ouverture.

La mesure se fait par exemple avec une caméra 36 en jouant sur la focalisation pour avoir une mesure de hauteur.

Cette mesure nous permet de remonter à la vitesse d'ablation laser.

Dans notre exemple, l'épaisseur de résine est de 1,5 mm.

Nous faisons une autre zone un peu plus petite 220 µm x 210 µm de façon à garder une marche M1. La hauteur de la marche M1 sera mesurée postérieurement pour déterminer de manière plus précise la vitesse d'ablation laser.

Ayant gardé la position du composant électronique, nous lançons directement l'ablation laser, sans réaligner la platine. La durée d'ablation est calculée de façon à laisser 700 µm de résine.

A nouveau, nous arrêtons et nous faisons une mesure de façon à mieux calibrer la vitesse de gravure et nous laissons une marche M2.

A ce moment là, nous passons, toujours sans sortir notre composant électronique de notre enceinte 16, à une gravure plasma. Avec un plasma physico-chimique de type (Reactive Ion Etching) RIE, la vitesse de gravure typique est de 27 µm/h. Nous faisons alors une première passe dans une zone de 210 µm x 210 µm pour calibrer la vitesse de gravure de la résine avec une marche M3.

Nous reprenons l'ablation laser de façon à laisser par exemple 200 µm de résine, sur une zone plus petite de 200 µm x 210 µm.

Lorsque nous arrêtons, nous nous apercevons qu'un bord du circuit est déjà visible. L'ablation laser est allée un peu plus loin que prévu. Dans notre exemple l'explication vient de la position en biais (verticalement) du circuit.

Nous choisissons alors de refaire une zone d'ablation pour mettre à nu le reste du circuit. La zone d'ablation a une forme triangulaire, en passant par les trois coins qui ne sont pas encore à nu.

En profondeur une pente est choisie de manière à avoir une profondeur plus importante dans un coin diamétralement opposé à celui qui est à nu.

Nous relançons l'ablation sur cette nouvelle zone triangulaire pour enlever 20 µm au plus bas, ce qui est déduit de notre estimation de la pente du biais en question.

Ensuite nous passons au plasma, sur une zone un peu plus large pour aller plus proche du circuit et nous mettons à nu le reste du circuit.

Si besoin, une ablation laser est à nouveau utilisée. Celle-ci peut à son tour être suivie d'une ablation plasma jusqu'à ce que le circuit soit totalement mis à nu.

Pour l'ouverture d'un second composant du même type, les vitesses de gravure peuvent être calibrées par la mesure fine des marches M1, M2 et M3 par exemple. De même la hauteur précise entre la surface de l'enrobage et le circuit intégré est mesurée sur le premier circuit et est utilisée comme référencé pour les circuits suivants.

L'ablation peut alors être lancée de manière à laisser environ 200 µm sur toute la surface du circuit. Cependant, suivant la confiance que l'on a sur la variabilité de la position du circuit d'un composant à l'autre on pourra par exemple se laisser de la marge (250 µm au lieu de 200 µm) ou au contraire viser une valeur plus faible (50 µm au lieu de 200 µm) de façon à aller plus vite pour le plasma.

Les plasmas utilisés sont des plasmas de gravure. Préférentiellement un plasma de type RIE (Reactive Ion Etching) entre ces deux plasmas est utilisé. Cependant, un plasma inductif de type ICP (Inductively Coupled Plasma) obtiendrait de très bonnes performances. La différence entre ces deux plasmas se situe entre la préparation du plasma qui se fait dans une chambre extérieure. Le plasma est ensuite transféré par un tube à la chambre où se trouve l'échantillon, la distance séparant les deux chambres étant typiquement de 10 cm.

Dans tous les cas, les plasmas de gravure peuvent avoir une vitesse de gravure inférieure à 120 µm par heure. Typiquement, lors de l'utilisation d'un plasma de type RIE, la vitesse est de 27 µm par heure.

## Revendications

1. Procédé de mise à nu d'un circuit intégré par ablation d'une enveloppe de polymère recouvrant initialement le circuit intégré, **caractérisé en ce qu'**il comporte une application combinée d'un rayonnement laser et d'un plasma sur l'enveloppe recouvrant initialement le circuit intégré, l'application combinée étant réalisée dans une même enceinte (16).

2. Procédé selon la revendication 1, **caractérisé en ce qu'**il comporte d'abord une étape (72) d'application d'un rayonnement laser puis une étape (74) d'application d'un plasma.

3. Procédé selon 2, **caractérisé en ce que** l'étape (74) d'application du plasma est initiée alors que le circuit intégré est toujours soumis à un rayonnement laser.

4. Procédé selon la revendication 2 ou 3, **caractérisé en ce que** l'application (72) du rayonnement laser est effectuée jusqu'à ce que l'épaisseur de la couche de polymère résiduelle au-dessus du circuit intégré soit comprise entre 50 et 200 *µ*m.

5. Procédé selon l'une quelconque des revendications 2 à 4, **caractérisé en ce qu'**il comporte deux phases successives de traitement d'abord par application d'un rayonnement laser puis par application d'un plasma.

6. Procédé selon l'une quelconque des revendications précédentes, **caractérisé en ce que** l'application (72) du rayonnement laser est effectuée alors que le circuit intégré est soumis à l'application d'un plasma.

7. Procédé selon l'une quelconque des revendications précédentes, **caractérisé en ce qu'**il comporte une étape de pulvérisation d'un flux gazeux vers la surface du circuit intégré propre à dégager les particules résiduelles présentes sur le circuit intégré.

8. Procédé selon l'une quelconque des revendications précédentes, **caractérisé en ce que** le plasma est un plasma sous vide.

9. Procédé selon l'une quelconque des revendications 1 à 7, **caractérisé en ce que** le plasma est un plasma atmosphérique.

10. Procédé selon l'une quelconque des revendications précédentes, **caractérisé en ce que** le plasma contient de l'oxygène et du tétra fluorure de carbone.

11. Procédé selon l'une quelconque des revendications précédentes, **caractérisé en ce qu'**il comporte une étape préalable de mise sous vide de l'enceinte (16) et **en ce que** ladite enceinte (16) reste sous vide pendant l'application combinée du rayonnement laser et du plasma.

12. Procédé de test d'arrachement des conducteurs de liaison d'un circuit intégré initialement recouvert par une enveloppe de polymère comprenant :
- une étape initiale (72, 74) de mise à nu du circuit intégré et des conducteurs de liaison par un procédé selon l'une quelconque des revendications précédentes, et
- une étape de test d'arrachement des conducteurs ainsi mis à nu.

13. Procédé de test selon la revendication 12 **caractérisé en ce que** l'application du plasma est propre à retirer le polymère résiduel et le polymère situé sur les conducteurs de liaison.

14. Installation de mise à nu d'un circuit intégré par ablation d'une enveloppe de polymère recouvrant initialement le circuit intégré comportant :
- des moyens (28) d'application d'un rayonnement laser vers la surface du circuit intégré ;
- des moyens d'application, combinée à l'application d'un rayonnement laser, d'une attaque par plasma sur l'enveloppe recouvrant initialement le circuit intégré ; et
- une platine (13) de support du circuit intégré lors de son traitement, les moyens (28) d'application du rayonnement laser et les moyens (46) d'application du plasma étant propres à agir sur la même platine de support (13).

## Claims

1. Method for exposing an integrated circuit by ablation of a polymer coating which initially covers the integrated circuit, **characterised in that** it comprises a combined application of laser radiation and a plasma to the coating which initially covers the integrated circuit, the combined application being carried out in the same vessel (16).

2. Method according to claim 1, **characterised in that** it comprises, firstly, a step (72) of applying laser radiation and then a step (74) of applying a plasma.

3. Method according to claim 2, **characterised in that** the step (74) of applying the plasma is started whilst the integrated circuit is still subjected to laser radiation.

4. Method according to claim 2 or claim 3, **characterised in that** the application (72) of the laser radiation is carried out until the thickness of the residual polymer coating above the integrated circuit is between 50 and 200 µm.

5. Method according to claim 2, **characterised in that** it comprises two successive processing steps, firstly, by application of laser radiation and then by application of a plasma.

6. Method according to any one of the preceding claims, **characterised in that** the application (72) of the laser radiation is carried out whilst the integrated circuit is subjected to the application of a plasma.

7. Method according to any one of the preceding claims, **characterised in that** it comprises a step of atomising a gas flow towards the surface of the integrated circuit capable of disengaging the residual particles which are present on the integrated circuit.

8. Method according to any one of the preceding claims, **characterised in that** the plasma is a reduced pressure plasma.

9. Method according to any one of the previous claims, **characterised in that** the plasma is an atmospheric plasma.

10. Method according to any one of the previous claims, **characterised in that** the plasma contains oxygen and carbon tetrafluoride.

11. Method according to any one of the previous claims, **characterised in that** it comprises a preceding step of reducing the pressure of the vessel (16) to create vacuum, and **in that** the vessel (16) remains under reduced pressure during the combined application of the laser radiation and the plasma.

12. Shear test method for the connection conductors of an integrated circuit which is initially covered by a polymer coating comprising:
- an initial step (72, 74) of exposing the integrated circuit and the connection conductors by a method according to any one of the preceding claims and
- a shear test step for the conductors which are exposed in this manner.

13. Test method according to claim 12, **characterised in that** the application of the plasma is capable of removing the residual polymer and the polymer located on the connection conductors.

14. Installation for exposing an integrated circuit by ablation of a polymer coating which initially covers the integrated circuit comprising:
- means (28) for applying laser radiation to the surface of the integrated circuit;
- means for applying, combined with the application of laser radiation, an attack by plasma to the coating which initially covers the integrated circuit; and
- a plate (13) for supporting the integrated circuit during the processing thereof, the application means (28) for the laser radiation and the application means (46) for the plasma being capable of acting on the same support plate (13).

## Patentansprüche

1. Verfahren zum Freilegen eines integrierten Schaltkreises durch Abtragen einer Polymerhülle, die anfänglich den integrierten Schaltkreis bedeckt,
**dadurch gekennzeichnet, dass**
es eine kombinierte Aufbringung einer Laserstrahlung und eines Plasmas auf die anfänglich den integrierten Schaltkreis bedeckende Hülle umfasst, wobei die kombinierte Aufbringung in einem selben Gehäuse (16) realisiert wird.

2. Verfahren nach Anspruch 1,
**dadurch gekennzeichnet, dass**
es zuerst einen Schritt (72) der Aufbringung einer Laserstrahlung und dann einen Schritt (74) der Aufbringung eines Plasmas umfasst.

3. Verfahren nach Anspruch 2,
**dadurch gekennzeichnet, dass**
der Schritt (74) der Aufbringung des Plasmas initiiert wird, während der integrierte Schaltkreis immer noch einer Laserstrahlung unterworfen wird.

4. Verfahren nach Anspruch 2 oder 3,
**dadurch gekennzeichnet, dass**
die Aufbringung (72) der Laserstrahlung durchgeführt wird, bis die Dicke der Restpolymerschicht über dem integrierten Schaltkreis zwischen 50 und 200 µm liegt.

5. Verfahren nach einem beliebigen der Ansprüche 2 bis 4,
**dadurch gekennzeichnet, dass**
es zwei aufeinanderfolgende Behandlungsphasen umfasst, zuerst die der Aufbringung einer Laserstrahlung, dann die der Aufbringung eines Plasmas.

6. Verfahren nach einem beliebigen der vorhergehenden Ansprüche,
**dadurch gekennzeichnet, dass**
die Aufbringung (72) der Laserstrahlung durchgeführt wird, während der integrierte Schaltkreis der Aufbringung eines Plasmas unterworfen wird.

7. Verfahren nach einem beliebigen der vorhergehenden Ansprüche,
**dadurch gekennzeichnet, dass**
es einen Schritt der Zerstäubung eines Gasstroms zu der Fläche des integrierten Schaltkreises hin umfasst, der geeignet ist, die auf dem integrierten Schaltkreis vorhandenen Restpartikel zu entfernen.

8. Verfahren nach einem beliebigen der vorhergehenden Ansprüche,
**dadurch gekennzeichnet, dass**
das Plasma ein Plasma unter Vakuum ist.

9. Verfahren nach einem beliebigen der Ansprüche 1 bis 7,
**dadurch gekennzeichnet, dass**
das Plasma ein atmosphärisches Plasma ist.

10. Verfahren nach einem beliebigen der vorhergehenden Ansprüche,
**dadurch gekennzeichnet, dass**
das Plasma Sauerstoff und Tetrafluorkohlenstoff enthält.

11. Verfahren nach einem beliebigen der vorhergehenden Ansprüche,
**dadurch gekennzeichnet, dass**
es einen vorangehenden Schritt des unter Vakuumsetzens des Gehäuses (16) umfasst, und dass das Gehäuse (16) unter Vakuum während der kombinierten Aufbringung der Laserstrahlung und des Plasmas verbleibt.

12. Testverfahren für das Abreißen von Verbindungsleitungen eines integrierten Schaltkreises, der anfänglich von einer Polymerumhüllung bedeckt ist, umfassend:
- einen Ausgangsschritt (72, 74) des Freilegens des integrierten Schaltkreises und der Verbindungsleitungen durch ein Verfahren nach einem beliebigen der vorhergehenden Ansprüche und
- einen Testschritt des Abreißens der so freigelegten Leitungen.

13. Testverfahren nach Anspruch 12,
**dadurch gekennzeichnet, dass**
die Aufbringung des Plasmas geeignet ist, das Restpolymer und das auf den Verbindungsleitungen liegende Polymer wegzunehmen.

14. Anlage zur Freilegung eines integrierten Schaltkreises durch Abtragen einer Polymerumhüllung, die anfänglich den integrierten Schaltkreis bedeckt, umfassend:
- Mittel (28) zur Aufbringung einer Laserstrahlung auf die Oberfläche des integrierten Schaltkreises;
- Mittel zur Aufbringung eines Angriffs durch Plasma, kombiniert mit der Aufbringung der Laserstrahlung, auf die anfänglich den integrierten Schaltkreis bedeckende Umhüllung; und
- eine Trägerplatte (13) für den integrierten Schaltkreis bei seiner Behandlung, wobei die Mittel (28) zur Aufbringung der Laserstrahlung und die Mittel (46) zur Aufbringung des Plasmas geeignet sind, auf dieselbe Trägerplatte (13) zu wirken.
